(19) **Europäisches Patentamt / European Patent Office / Office européen des brevets**

(11) **EP 1 897 861 A1**

(12) **EUROPEAN PATENT APPLICATION**

(43) Date of publication:
**12.03.2008 Bulletin 2008/11**

(21) Application number: **07114474.5**

(22) Date of filing: **16.08.2007**

(51) Int Cl.:
*C03C 3/066* (2006.01)  *C03C 3/091* (2006.01)
*C03C 3/093* (2006.01)  *C03C 8/02* (2006.01)
*C03C 8/04* (2006.01)  *C03C 27/06* (2006.01)
*B32B 17/06* (2006.01)  *H01L 51/52* (2006.01)
*C03C 8/24* (2006.01)  *C03C 27/10* (2006.01)

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **18.08.2006 US 506218**

(71) Applicant: **Corning Incorporated
Corning, New York 14831 (US)**

(72) Inventors:
• **Boek, Heather Debra
Corning, NY 14830 (US)**
• **Danielson, Paul Stephen
Corning, NY 14830 (US)**
• **Morena, Robert Michael
Lindley, NY 14858 (US)**
• **Reddy, Kamjula Pattabhirami
Corning, NY 14830 (US)**

(74) Representative: **Marchant, James Ian
Elkington and Fife LLP
Prospect House
8 Pembroke Road
Sevenoaks, Kent TN13 1XR (GB)**

(54) **Boro-silicate glass frits for hermetic sealing of light emitting device displays**

(57) A frit composition useful for sealing a light emitting device is disclosed. The frit composition comprises a glass portion comprising a base component and at least one absorbing component. The glass portion of the frit comprises silica, boron oxide, optionally alumina, and (a) cupric oxide and/or a (b) combination of ferric oxide, vanadium pentoxide, and optionally titanium dioxide. Also disclosed is an article comprising a substrate and a frit, and a glass package comprising two substrates and a frit positioned between the substrates. A method for manufacturing a hermetically sealed glass package comprising the deposition of a glass frit and heating of the glass frit to form a hermetic seal is also disclosed

EP 1 897 861 A1

**Description**

**BACKGROUND OF THE INVENTION**

**FIELD OF THE INVENTION**

The present invention relates to hermetically sealed glass packages that are suitable to protect thin film devices that are sensitive to the ambient environment.

**TECHNICAL BACKGROUND**

Light emitting devices have been the subject of considerable research in recent years. Organic light emitting devices (OLED) are of particular interest because of their use and potential use in a wide variety of electroluminescent devices. A single OLED, for example, can be used in a discrete light emitting device, or an array of OLEDs can be used in lighting applications or flat-panel display applications, such as OLED displays. Traditional OLED displays are known as being very bright and having a good color contrast and wide viewing angle. However, traditional OLED displays and in particular the electrodes and organic layers located therein are susceptible to degradation resulting from interaction with oxygen and moisture leaking into an OLED display from the ambient environment. It is well known that the life of an OLED display can be significantly increased if the electrodes and organic layers within an OLED display are hermetically sealed from the ambient environment. Unfortunately, it has historically been very difficult to develop a sealing process to hermetically seal a light emitting display.

Some of the factors required to properly seal a light emitting display are briefly mentioned below:

The hermetic seal should provide a barrier for oxygen ($10^{-3}$ cc/m$^2$/day) and water ($10^{-6}$ g/m$^2$/day).

The width of the hermetic seal should be minimal, for example, less than two millimeters, so that it does not have an adverse effect on size of a light emitting display.

The temperature generated during the sealing process should be sufficiently low as to not damage the materials, for example, electrodes and organic layers, within a light emitting display. For instance, the first pixels of OLEDs which are located 1-2 millimeters from the seal in an OLED display should be heated to no more than 100 °C during the sealing process.

The gases released during the sealing process be compatible with the materials within a light emitting display.

The hermetic seal should enable electrical connections, for example, thin-film chromium, to enter a light emitting display.

There is a need to address the aforementioned problems and other shortcomings associated with the traditional seals and the traditional approaches for sealing light emitting displays. These needs and other needs are satisfied by the hermetic sealing technology of the present invention.

**SUMMARY OF THE INVENTION**

The present invention relates to an article, and more particularly to a frit composition for use in sealing a device, such as a light emitting device. The present invention addresses at least a portion of the problems described above through the use of a novel frit composition.

In a first aspect, the present invention provides a frit composition comprising a glass portion comprising: a base component comprising from about 5 to about 75 mole % $SiO_2$; from about 10 to about 40 mole % $B_2O_3$; from 0 to about 20 mole % $Al_2O_3$; and at least one absorbing component comprising: (a) from greater than 0 to about 25 mole % $CuO$; or (b) from greater than 0 to about 7 mole % $Fe_2O_3$; from greater than 0 to about 10 mole % $V_2O_5$; and from 0 to about 5 mole % $TiO_2$.

In a second aspect, the present invention further provides an article comprising a substrate; and the frit composition described above positioned on and affixed to the substrate.

In another aspect, the present invention provides a glass package comprising a first substrate; a second substrate; and the frit composition described above positioned between the first substrate and the second substrate, wherein the frit was heated to form a hermetic seal connecting the first substrate to the second substrate.

In yet another aspect, the present invention provides a method for manufacturing a hermetically sealed glass package, comprising the steps of providing a first substrate; providing a second substrate; depositing the frit composition described above; and sealing the first substrate to the second substrate by heating the frit in a manner that would cause the frit to soften and form a hermetic seal.

In yet another aspect, the present invention provides a vanadium based frit composition having a coefficient of thermal expansion substantially similar to that of borosilicate glass, without the addition to the frit composition of a coefficient of thermal expansion matching filler.

In yet another aspect, the present invention provides a copper based frit composition having a coefficient of thermal expansion substantially similar to that of borosilicate glass, without the addition to the frit composition of a coefficient of thermal expansion matching filler.

Additional aspects and advantages of the invention will be set forth, in part, in the detailed description, figures, and any claims which follow, and in part will be derived from the detailed description or can be learned by practice of the invention. The advantages described below will be realized and attained by means of the elements and combinations particularly pointed out in the appended claims. It is to be understood that both the foregoing general description and the following detailed description are exemplary and explanatory only and are not restrictive of the invention as disclosed.

## BRIEF DESCRIPTION OF THE DRAWINGS

The accompanying drawings, which are incorporated in and constitute a part of this specification, illustrate certain aspects of the present invention and together with the description, serve to explain, without limitation, the principles of the invention. Like numbers represent the same elements throughout the figures.

FIGS. 1A and 1B are a top view and a cross-sectional side view illustrating the basic components of a hermetically sealed OLED display in accordance with one aspect of the present invention.

FIG. 2 is a flowchart illustrating the steps of an exemplary method for manufacturing the hermetically sealed OLED display shown in FIGS. 1A and 1B.

FIG. 3 is a perspective view illustrating two substrates hermetically sealed by a laser, in accordance with one aspect of the present invention.

FIG. 4A is a diagram illustrating a laser and a split-beam optic arrangement that can be used to heat two sides of substrates in accordance with one aspect of the present invention.

FIG. 4B is a top view of a preformed frit placed a small distance away from the free edges of a substrate in accordance with one aspect of the present invention.

## DETAILED DESCRIPTION OF THE INVENTION

The present invention can be understood more readily by reference to the following detailed description, drawings, examples, and claims, and their previous and following description. However, before the present compositions, articles, devices, and methods are disclosed and described, it is to be understood that this invention is not limited to the specific compositions, articles, devices, and methods disclosed unless otherwise specified, as such can, of course, vary. It is also to be understood that the terminology used herein is for the purpose of describing particular aspects only and is not intended to be limiting.

The following description of the invention is provided as an enabling teaching of the invention in its currently known embodiments. To this end, those skilled in the relevant art will recognize and appreciate that many changes can be made to the various aspects of the invention described herein, while still obtaining the beneficial results of the present invention. It will also be apparent that some of the desired benefits of the present invention can be obtained by selecting some of the features of the present invention without utilizing other features. Accordingly, those who work in the art will recognize that many modifications and adaptations to the present invention are possible and can even be desirable in certain circumstances and are a part of the present invention. Thus, the following description is provided as illustrative of the principles of the present invention and not in limitation thereof.

Disclosed are materials, compounds, compositions, and components that can be used for, can be used in conjunction with, can be used in preparation for, or are products of the disclosed method and compositions. These and other materials are disclosed herein, and it is understood that when combinations, subsets, interactions, groups, etc. of these materials are disclosed that while specific reference of each various individual and collective combinations and permutation of these compounds may not be explicitly disclosed, each is specifically contemplated and described herein. Thus, if a class of substituents A, B, and C are disclosed as well as a class of substituents D, E, and F and an example of a combination embodiment, A-D is disclosed, then each is individually and collectively contemplated. Thus, in this example, each of the combinations A-E, A-F, B-D, B-E, B-F, C-D, C-E, and C-F are specifically contemplated and should be considered disclosed from disclosure of A, B, and C; D, E, and F; and the example combination A-D. Likewise, any subset or combination of these is also specifically contemplated and disclosed. Thus, for example, the sub-group of A-E, B-F, and C-E are specifically contemplated and should be considered disclosed from disclosure of A, B, and C; D, E, and F; and the example combination A-D. This concept applies to all aspects of this disclosure including, but not limited to any components of the compositions and steps in methods of making and using the disclosed compositions. Thus, if there are a variety of additional steps that can be performed it is understood that each of these additional steps can be performed with any specific embodiment or combination of embodiments of the disclosed methods, and that each such combination is specifically contemplated and should be considered disclosed.

In this specification and in the claims which follow, reference will be made to a number of terms which shall be defined to have the following meanings:

As used herein, the singular forms "a," "an" and "the" include plural referents unless the context clearly dictates otherwise. Thus, for example, reference to a "component" includes aspects having two or more such components, unless the context clearly indicates otherwise.

"Optional" or "optionally" means that the subsequently described event or circumstance can or cannot occur, and that the description includes instances where the event or circumstance occurs and instances where it does not. For example, the phrase "optionally substituted component" means that the component can or can not be substituted and that the description includes both unsubstituted and substituted aspects of the invention.

Ranges can be expressed herein as from "about" one particular value, and/or to "about" another particular value. When such a range is expressed, another aspect includes from the one particular value and/or to the other particular value. Similarly, when values are expressed as approximations, by use of the antecedent "about," it will be understood that the particular value forms another aspect. It will be further understood that the endpoints of each of the ranges are significant both in relation to the other endpoint, and independently of the other endpoint.

As used herein, a "wt. %" or "weight percent" or "percent by weight" of a component, unless specifically stated to the contrary, refers to the ratio of the weight of the component to the total weight of the composition in which the component is included, expressed as a percentage.

As used herein, a "mole percent" or "mole %" of a component, unless specifically stated to the contrary, refers to the ratio of the number of moles of the component to the total number of moles of the glass portion of the frit composition in which the component is included, on an oxide basis and expressed as a percentage.

As used herein, a "frit" or "frit composition," unless specifically stated to the contrary, refers to mixture of base and absorbing components, and optionally filler. The term "frit" or "frit composition" can refer to any physical form of a frit, including a powder, a paste, an extruded bead, and can also refer to an attached or unattached frit deposited on a substrate.

The following US Patents and published applications describe various compositions and methods for sealing light emitting devices, and they are hereby incorporated by reference in their entirety and for the specific purpose of disclosing materials and methods relating to the formation of hermetic seals with light emitting devices: US Patent 6,998,776; US Patent Publication US2005/0001545; and US Patent Publication 2006/0009109.

As briefly introduced above, the present invention provides an improved frit composition that, for example, can be useful in sealing a light emitting device. The frit composition, article, device, and methods of the present invention relate to a frit seal, which should be distinguished from a direct glass seal that does not utilize a frit.

There are several considerations which should be kept in mind when designing a frit that can be used to make a hermetically sealed light emitting display. Following is a list of some of these considerations:

Sealing temperature - To avoid thermal degradation of the light emitting materials, such as an OLED, a frit should seal at a temperature sufficiently low that the temperature experienced a short distance (1-3 mm) from the sealed edge in the OLED display should not exceed approximately 100 °C.

Expansion compatibility - The coefficient of thermal expansion (CTE) of the frit should be substantially matched with that of the substrates to limit sealing stresses and thereby eliminate hermeticity loss by fractures in the seal.

Hermeticity - The frit should form a hermetic seal and provide long-term protection for the materials in the light emitting display.

The requirement that frit-sealing be accompanied by only a minimal temperature rise in the adjacent light emitting materials can be satisfied with the absorbing frit of the present invention.

### DEVICE

The device of the present invention can be any device requiring two substrates to be sealed together. In one aspect, the device is a light emitting display, such as a polymer light emitting device (PLED). In a preferred aspect, the device is an OLED, such as an active or passive OLED display. With reference to the drawings, a hermetically sealed OLED display 100 and a method for manufacturing the OLED display are disclosed, in accordance with the present invention. Although the sealing process of the present invention is described below with respect to the fabrication of a hermetically sealed OLED display, it should be understood that the same or similar sealing process can be used in other applications where two substrates need to be sealed to one another. Accordingly, the present invention should not be construed in a limited manner.

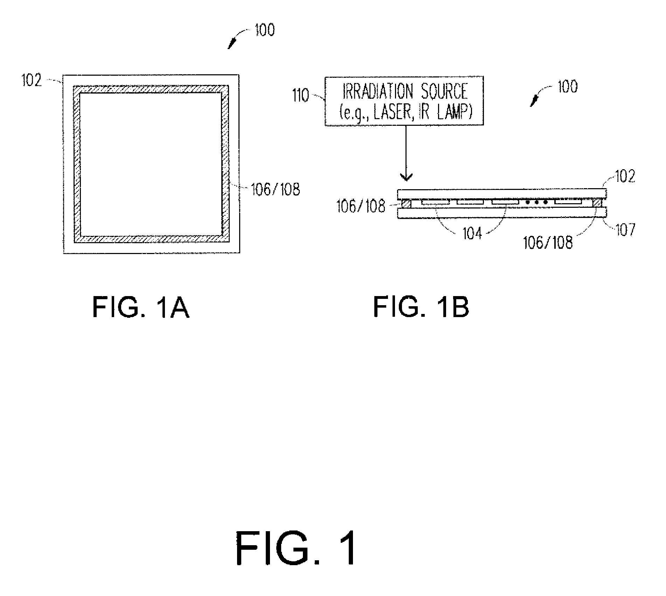

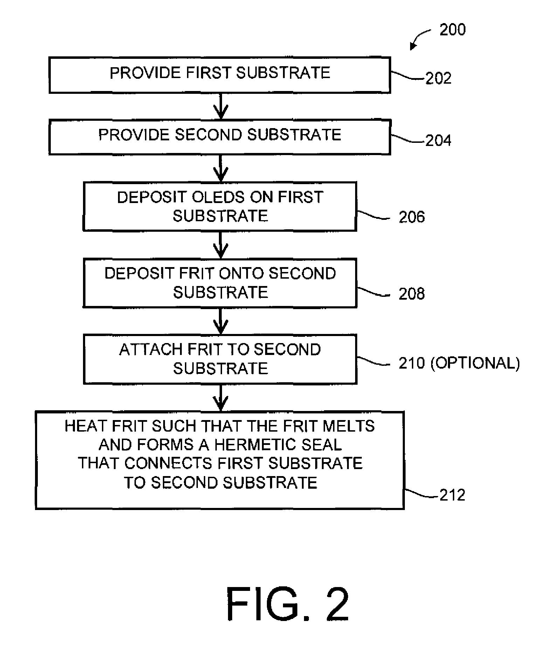

FIGS. 1A and 1B depict an exemplary top view and cross-sectional side view illustrating the basic components of a hermetically sealed OLED display **100.** The OLED display **100** includes a multilayer sandwich of a first substrate **102,** an OLED array **104,** a frit **106,** and a second substrate **107.** The OLED display **100** has a hermetic seal **108** formed from the frit **106** which protects the OLED **104** located between the first substrate **102** and the second substrate **107.** The hermetic seal **108** is typically located around the perimeter of the OLED display **100.** The OLED is typically located within a perimeter of the hermetic seal. The manner in which the hermetic seal is formed from the frit and the ancillary components, such as the radiation source **110** used to form the hermetic seal **108,** are described in greater detail below with respect to FIGS. 2-4.

## SUBSTRATE

The first and second substrates of the present invention can comprise any glass material appropriate for the type of device being fabricated. In various aspects, at least one substrate comprises a borosilicate glass, a soda-lime glass, or a mixture thereof. In one aspect, at least one substrate is a transparent glass. Such transparent glasses can be, for example, those manufactured and sold by Corning Incorporated (Corning, New York, USA) under the brand names of Code 1737 glass, Eagle $^{2000}$ ™, and Eagle XG ™; Asahi Glass Co., LTD (Tokyo, Japan), for example OA10 glass and OA21 glass; Nippon Electric Glass Co., LTD (Otsu, Shiga, Japan); NH Techno Glass Korea Corporation (Kyunggi-do, Korea); and Samsung Corning Precision Glass Co. (Seoul, Korea). It is not necessary that the first and second substrate be the same or comprise the same type of glass. In one aspect they are similar or identical types of glasses. In a preferred aspect, both the first and second substrates comprise a borosilicate glass, such as Eagle XG ™.
The dimensions of the substrates can be any such dimensions suitable for the device being fabricated. In one aspect, at least one substrate is about 0.6 mm thick.
Other properties of the substrates will vary depending upon the specific composition thereof. In one aspect, the substrates of the present invention have a CTE of from about $25 \times 10^{-7}$ /°C to about $80 \times 10^{-7}$ /°C. In another aspect, the softening temperature of the substrates is from about 970 °C to about 990 °C.
In a preferred aspect, the substrates of the present invention are comprised of material transparent to radiation at the wavelength of the radiation source used to seal the device.

## FRIT

The frit of the present invention can comprise any combination of glass and/or doped glass materials capable of forming a hermetic seal between two substrates. The frit of the present invention should be capable of absorbing radiation and should preferably have a CTE substantially similar to that of the substrates. In one aspect, the frit absorbs a larger amount of radiation at a particular wavelength, for example at 810 nanometers, than the first and second substrates. In another aspect, the frit has a softening temperature equal to or lower than the first and second substrates. In another aspect, the frit is durable upon exposure to chemicals and water. In yet another aspect, the frit is capable of bonding to both the first and the second substrates. In still another aspect, the frit is capable of sealing around electrical connections passing through the device. In another aspect, the frit is a dense material exhibiting very low porosity, for example, less than about 10 volume percent. In another aspect, the frit is free of or substantially free of heavy metals, such as lead and cadmium. In this aspect, the heavy metals, such as the lead and cadmium, should be minimized, typically to levels below 1 mole %, preferably below 0.1 mole %, for each heavy metal component.
The frit of the present invention comprises a glass portion; optionally a softening temperature, CTE, and/or absorbance adjusting filler; and optionally a paste binder and/or paste filler, as discussed below. The frit can exist in a variety of physical forms, including a powder, a paste, and/or an extruded bead.
The glass portion of the frit comprises a base component and at least one absorbing component. The base component of the glass portion of the frit comprises silicon dioxide, boron oxide, and optionally aluminum oxide. The absorbing component of the glass portion of the frit comprises (a) a cupric oxide and/or (b) a combination of ferric oxide, vanadium pentoxide, and optionally titanium dioxide. Thus, the glass portion of the frit comprises silicon dioxide, boron oxide, and optionally aluminum oxide, together with (a) a cupric oxide and/or (b) a combination of ferric oxide, vanadium oxide, and optionally titanium dioxide. Among other aspects described in detail below, the inventive frit composition comprises from about 5 to about 75 mole percent silicon dioxide, from about 10 to about 40 mole percent boron oxide, from 0 to about 20 mole percent aluminum oxide, and at least one of the following: a) from greater than 0 to about 25 mole percent cupric oxide; or b) from greater than 0 to about 7 mole percent ferric oxide, from greater than 0 to about 10 mole percent vanadium pentoxide, and from 0 to about 5 mole percent titanium dioxide.
The ranges for each compound in the base and absorbing components are summarized in Table 1 below. Exemplary aspects detailing particular ranges and combinations are described below.

**Table 1**

| Compound | Mole % Range |
| --- | --- |
| Silicon Dioxide | 5-75 |
| Boron Oxide | 10-40 |
| Aluminum Oxide | 0-20 |
| Zinc Oxide | 0-60 |
| Cupric Oxide | 0-25 |
| Ferric Oxide | 0-7 |
| Vanadium Pentoxide | 0-10 |
| Titanium Dioxide | 0-5 |

In various aspects, the amount of silicon dioxide in the glass portion of the frit comprises from about 5 to about 75 mole percent, for example, 5, 6, 7, 10, 20, 40, 50, 54, 56, 58, 60, 64, 68, 70, 72, 73, 74, or 75 mole percent; from about 50 to about 75 mole percent; or from about 54 to about 70 mole percent. In a further aspect, a portion of silicon dioxide, for example, up to about 55 mole percent, and optionally at least a portion of other components, can be replaced with a base component amount of up to about 60 mole percent zinc oxide. Thus, the zinc oxide is considered, when present, to be part of the base component. In other aspects, the amount of zinc oxide in the glass portion of the frit comprises from about 0.1 to about 60 mole percent; from about 5 to about 60 mole percent; from about 30 to about 60 mole percent; or from about 40 to about 55 mole percent. Zinc oxide can be used to soften a glass frit composition without adversely affecting the CTE. In a further aspect, the glass portion of the frit comprises from about 5 to about 30 mole percent silicon dioxide, from about 10 to about 40 mole percent boron oxide, from 0 to about 10 mole percent aluminum oxide, and from about 30 to about 60 mole percent zinc oxide. In a further aspect, the glass portion of the frit comprises from about 8 to about 15 mole percent silicon dioxide, from about 25 to about 35 mole percent boron oxide, from about 0 to about 10 mole percent aluminum oxide, and from about 40 to about 55 mole percent zinc oxide.

In various aspects, the amount of boron oxide in the glass portion of the frit comprises from about 10 to about 40 mole percent, for example 10, 11, 12, 15, 19, 20.5, 22.5, 24, 25, 30, 35, or 40 mole percent; from about 15 to about 30 mole percent; or from about 19 to about 24 mole percent.

In various aspects, the amount of aluminum oxide in the glass portion of the frit comprises from 0 to about 20 mole percent, for example, 0, 0.1, 1, 2, 4, 7, 8, 9, 10, 14, 16, 19, or 20 mole percent; from 0 to about 10 mole percent; or from about 1 to about 8 mole percent.

In various aspects, the amount of cupric oxide in the glass portion of the frit comprises from greater than 0 to about 25 mole percent, for example, 0.1, 0.5, 1, 2, 4, 6, 8, 12, 14, 16, 18, 20, 22, 23, 24, or 25 mole percent; from about 4 to about 18 mole percent; from about 6 to about 16 mole percent; or from about 8 to about 14 mole percent. The addition of cupric oxide to a borosilicate glass can increase the optical absorption of the glass, for example, at 810 nanometers, and can soften the glass without increasing the CTE. In further aspects, the glass portion of the frit comprises ferric oxide, vanadium pentoxide, and/or titanium dioxide, individually or in combination, together with cupric oxide in the ranges described above. For example, the glass portion of the frit can comprise from greater than 0 to about 25 mole percent cupric oxide and from 0 to about 7 mole percent ferric oxide without vanadium pentoxide and titanium dioxide.

In various aspects, the amount of ferric oxide in the glass portion of the frit comprises from greater than 0 to about 7 mole percent, for example, 0.1, 0.5, 1, 2, 3, 5, 6, or 7 mole percent; from about 0.1 to about 3 mole percent; or from about 1 to about 2 mole percent.

In various aspects, the amount of vanadium pentoxide in the glass portion of the frit comprises from greater than 0 to about 10 mole percent, for example, 0.1, 0.5, 1, 2, 5, 7, 8, 9, or 10 mole percent; from about 0.1 to about 5 mole percent; or from about 0.5 to about 2 mole percent.

In various aspects, the amount of titanium dioxide in the glass portion of the frit comprises from 0 to about 5 mole percent, for example, 0, 0.1, 0.5, 1, 2, 3, 4, or 5 mole percent; from 0 to about 2 mole percent; from 0 to about 1 mole percent; from about 0.1 to about 2 mole percent; or from about 0.1 to about 1 mole percent.

In one aspect, the base component comprises from about 5 to about 75 mole percent silicon dioxide, from about 10 to about 40 mole percent boron oxide, and from 0 to about 20 mole percent aluminum oxide. In another aspect, the base component comprises from about 50 to about 75 mole percent silicon dioxide, from about 15 to about 30 mole percent boron oxide, and from 0 to about 10 mole percent aluminum oxide. In another aspect, the base component comprises from about 54 to about 70 mole percent silicon dioxide, from about 19 to about 24 mole percent boron oxide, and from about 1 to about 8 mole percent aluminum oxide. In another aspect, the base component comprises from about 56 to about 68 mole percent silicon dioxide, from about 20.5 to about 22.5 mole percent boron oxide, and from about 2 to about 7 mole percent aluminum oxide.

In a first aspect, the absorbing component comprises from greater than 0 to about 25 mole percent cupric oxide, from about 4 to about 18 mole percent cupric oxide, from about 6 to about 16 mole percent cupric oxide, or from about 8 to about 14 mole percent cupric oxide.

In a second aspect, the absorbing component comprises from greater than 0 to about 7 mole percent ferric oxide, from greater than 0 to about 10 mole percent vanadium pentoxide, and from 0 to about 5 mole percent titanium dioxide. In another aspect, the absorbing component comprises from about 0.1 to about 3 mole percent ferric oxide, from about 0.1 to about 5 mole percent vanadium pentoxide, and from 0 to about 2 mole percent titanium dioxide. In another aspect, the absorbing component comprises from about 0.1 to about 3 mole percent ferric oxide, from about 0.1 to about 5 mole percent vanadium pentoxide, and from about 0.1 to about 2 mole percent titanium dioxide. In another aspect, the absorbing component comprises from about 1 to about 2 mole percent ferric oxide, from about 0.5 to about 2 mole percent vanadium pentoxide, and from about 0.1 to about 1 mole percent titanium dioxide.

In another aspect, the absorbing component comprises both the first and second aspects above, that is, the absorbing component has both the cupric oxide and ferric oxide/vanadium pentoxide/titanium dioxide absorbing components. In a further aspect, the absorbing component comprises from greater than 0 to about 25 mole percent cupric oxide, from greater than 0 to about 7 mole percent ferric oxide, from greater than 0 to about 10 percent vanadium pentoxide, and from 0 to about 5 mole percent titanium dioxide. In a further aspect, the absorbing component comprises from about 4 to about 18 mole percent cupric oxide, from greater than 0 to about 3 mole percent ferric oxide, from greater than 0 to about 5 percent vanadium pentoxide, and from 0 to about 2 mole percent titanium dioxide. In a further aspect, the absorbing component comprises from about 6 to about 16 mole percent cupric oxide, from about 0.1 to about 3 mole percent ferric oxide, from about 0.1 to about 5 percent vanadium pentoxide, and from 0 to about 2, or about 0.1 to about 2 mole percent titanium dioxide. In a further aspect, the absorbing component comprises from about 8 to about 14 mole percent cupric oxide, from about 1 to about 2 mole percent ferric oxide, from about 0.5 to about 2 mole percent vanadium pentoxide, and from 0 to about 1, or about 0.1 to about 1 mole percent titanium dioxide.

In another aspect, the glass portion of the frit comprises from about 5 to about 75 mole percent silicon dioxide, from about 10 to about 40 mole percent boron oxide, from 0 to about 20 mole percent aluminum oxide; and from greater than 0 to about 25 mole percent cupric oxide and/or the combination of from greater than 0 to about 7 mole percent ferric oxide, from greater than 0 to about 10 mole percent vanadium pentoxide, and from 0 to about 5 mole percent titanium dioxide.

In another aspect, the glass portion of the frit comprises from about 50 to about 75 mole percent silicon dioxide, from about 15 to about 30 mole percent boron oxide, from 0 to about 10 mole percent aluminum oxide; and from about 4 to about 18 mole percent cupric oxide and/or the combination of from about 0.1 to about 3 mole percent ferric oxide, from about 0.1 to about 5 mole percent vanadium pentoxide, and from 0 to about 2 mole percent titanium dioxide.

In another aspect, the glass portion of the frit comprises from about 50 to about 75 mole percent silicon dioxide, from about 15 to about 30 mole percent boron oxide, from 0 to about 10 mole percent aluminum oxide, and from about 8 to about 14 mole percent cupric oxide and/or from about 1 to about 2 mole percent ferric oxide, from about 0.5 to about 2 mole percent vanadium pentoxide, and from 0 to about 1 mole percent titanium dioxide. In another aspect, the glass portion of the frit comprises from about 54 to about 70 mole percent silicon dioxide, from about 19 to about 24 mole percent boron oxide, from 0 to about 10 mole percent aluminum oxide, and from about 4 to about 18 mole percent cupric oxide and/or from about 0.1 to about 3 mole percent ferric oxide, from about 0.1 to about 5 mole percent vanadium pentoxide, and from 0 to about 2 mole percent titanium dioxide.

In another aspect, the glass portion of the frit comprises from about 54 to about 70 mole percent silicon dioxide, from about 19 to about 24 mole percent boron oxide, from 0 to about 10 mole percent aluminum oxide; and from about 8 to about 14 mole percent cupric oxide and/or the combination of from about 1 to about 2 mole percent ferric oxide, from about 0.5 to about 2 mole percent vanadium pentoxide, and from 0 to about 1 mole percent titanium dioxide.

The frit of the present invention preferably absorbs radiation at a particular wavelength, for example 810 nanometers, more strongly than the first and second substrates. The selection of an appropriate absorbing component can be made so as to enhance absorption at the specific wavelength of the radiation source as compared to the substrates. Selection of appropriate absorbing components will allow the frit to soften and form a hermetic seal when radiation at the specific wavelength of the radiation source contacts and is absorbed by the frit.

In contrast, the substrates should be chosen such that they absorb substantially little or no radiation from the radiation source, minimizing the undesirable transfer of heat from the forming hermetic seal to the light emitting material. The temperature of OLED materials should typically be maintained at or below about 80-100 °C during the sealing process.

For the purposes of this invention, absorbance can be defined as follows:

$$\beta = -\log_{10}[T/(1-R)^2] / t,$$

wherein β refers to the absorption coefficient, T refers to the fraction of light transmitted through thickness t, and R refers to reflectance.

The absorption coefficient of the frit should be greater than about 2/mm at the radiation wavelength. In one aspect, the absorption coefficient of the frit is about 2/mm. In a preferred aspect, the absorption coefficient of the frit is at least about 4/mm. In a more preferred aspect, the absorption coefficient of the frit is at least about 5/mm. Frits comprising iron, vanadium, and titanium can exhibit absorption coefficients as high as at least about 33/mm.

The frit of the present invention should also have a CTE substantially similar to that of the first and second substrates to provide a durable hermetic seal and prevent cracks. In one aspect, the frit has a CTE of from about 10 x $10^{-7}$/°C below to about 5 x $10^{-7}$/°C above that of the first and second substrates. In a preferred aspect, the frit has a CTE of from about 3 x $10^{-7}$/°C below to about 3 x $10^{-7}$/°C above that of the first and second substrates. In one aspect, the frit does not require addition of other materials, such as fillers, to provide the CTE matching properties described above. Thus, the frit can have a substantially similar CTE to the substrates in the absence of a CTE matching filler. In a specific aspect, the frit is comprised of the metal oxides of silicon, boron, optionally aluminum, copper, iron, vanadium, and optionally titanium, without a CTE matching filler.

In another aspect, the frit is any vanadium based frit having a CTE substantially similar, for example, from about 10 x $10^{-7}$/°C below to about 5 x $10^{-7}$/°C above that of the first and second substrates, without the addition of a CTE filler. In a further aspect, the frit is a vanadium based frit that is free of or substantially free of lead, for example, less than 1 mole %, preferably less than 0.1 mole % lead. In another aspect, the frit is any copper based frit having a CTE substantially similar, for example, from about 10 x $10^{-7}$/°C below to about 5 x $10^{-7}$/°C above that of the first and second substrates, without the addition of a CTE filler. In a further aspect, the frit is a copper based frit that is free of or substantially free of lead, for example, less than 1 mole %, preferably less than 0.1 mole % lead.

The frit of the present invention can further comprise a filler to adjust the softening temperature, CTE, and/or absorbance of the frit composition. Such materials can include, for example, lithium oxide, sodium monoxide, potassium oxide, bismuth oxide, nickel oxide, manganese oxide, other additive or inversion fillers, or a mixture thereof.

## PREPARATION AND APPLICATION OF FRIT

The glass portion of the frit can be formed by combining the desired base and absorbing components, heating the mixture to a temperature sufficient to melt the components, for example about 1,550 °C, allowing the materials to mix, and subsequently cooling the resulting mixture. The resulting composition can be fractured by subjecting it to thermal shock, for example, by pouring cold water or liquid nitrogen over it. If necessary, the fractured pieces can be further crushed and milled to a desired particle size. In one aspect, fractured pieces are crushed to an approximate 325 mesh size and subsequently wet milled to an average particle size of approximately 1.9 micrometers.

A frit paste can then be formulated for dispensing onto a substrate by mixing the glass portion of the frit with other materials, such as a paste binder and/or paste filler to allow handling and dispensing of the frit paste. The paste binder and/or paste filler material utilized to make a frit paste is distinguished from the softening temperature, CTE and/or absorbance adjusting filler referenced above. The selection of a paste binder or paste filler is dependent upon the desired frit paste rheology and application technique. Typically, a solvent is also added. In one aspect, the frit paste can comprise an ethylcellulose paste binder, such as T-100, available from Hercules, Inc. (Wilmington, Delaware, USA), and an organic solvent, such as TEXANOL®, available from Eastman Chemical Company (Kingsport, Tennessee, USA). One of skill in the art could readily select appropriate paste binder, paste filler, and solvent for a particular application.

The frit paste can be applied to a substrate by any appropriate technique. In one aspect, a frit paste is applied using a MicroPen® dispensing device, available from OhmCraft, Inc., Honeoye Falls, New York, USA. In another aspect, a frit paste is applied using a screen-printing technique. The frit paste can be applied in any pattern suitable for sealing a device. For an OLED, the frit paste is typically applied in the form of a frame near the edge of the substrate.

## SEALING

With reference again to the drawings, the flowchart of FIG. 2 illustrates the steps of an exemplary method **200** for manufacturing a hermetically sealed OLED display **100**. Beginning at steps **202** and **204**, a first substrate **102** and a second substrate **107** are provided so that one can manufacture an OLED display **100**. At step **206**, the OLED **104** and other circuitry can be deposited onto the first substrate **102**. A typical OLED **104** includes an anode electrode, one or more organic layers and a cathode electrode. However, it should be readily appreciated by those skilled in the art that any known OLED **104** or future OLED **104** can be used in the OLED display **100**. Again, it should be appreciated that this step can be skipped if an OLED display **100** is not being made but instead a glass package is being made using the sealing process of the present invention.

At step **208**, the frit (or frit paste) can be deposited along the edges of the second substrate. For instance, the frit can be placed approximately 1 mm away from the free edges of the second substrate. The compositions of several exemplary frits **106** are provided above and also below in Example 1.

At step **210** (optional), the frit which was deposited at step **208** onto the second substrate **107** can be heated so that it becomes attached to the second substrate, forming a fritted sheet. During heating, the porosity of the frit is also reduced. The fritted sheet can be sold as a unit to a light emitting display manufacturer.

At step **212**, the frit is heated by the radiation source **110**, for example, a laser **110a,** in a manner so that the frit forms the hermetic seal connecting the first substrate to the second substrate (see FIG. 1B). The hermetic seal also protects the OLED by preventing oxygen and moisture in the ambient environment from entering the OLED display. As shown in FIGS. 1A and 1 B, the hermetic seal is typically located just inside the outer edges of the OLED display. The frit can be heated using a variety of radiation sources such as a laser or an infrared lamp.

It should be noted that the above method is exemplary in nature and is not intended to be limiting. The steps of the process, as described above and in FIG. 2, can be performed in various orders. For example, and not intending to be limiting, step **206** can be performed before, after, or simultaneous to step **208**, and step **210**, when present, can be performed before, after, or simultaneous to steps **202** and **206**. The frit can be applied to a substrate at any time prior to sealing the device. In one aspect, the frit is applied to a substrate and heated to affix the frit to the substrate. In a further aspect, the frit is applied to a substrate in a pattern suitable for fabricating an OLED. The first substrate and the OLED material can be combined with the fritted sheet at a later time when the frit is heated to form a hermetic seal. In another aspect, frit can be applied to either the first or the second substrate at the time the device is fabricated and sealed.

**RADIATION SOURCE**

The radiation source of the present invention can be any radiation source which emits radiation at a wavelength corresponding to the absorbing component of the glass portion of the frit. For example, a frit comprising cupric oxide or a combination of ferric oxide, vanadium pentoxide, and titanium dioxide can be heated with a laser operating at 810 nanometers.

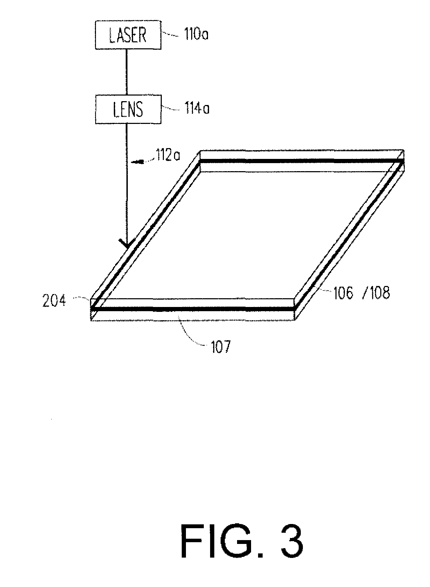

The laser can comprise additional optical components, as depicted in FIG. 3, such as a lens **114a**, to direct or focus the laser beam **112a** onto the frit. The laser beam can be moved in a manner to effectively heat and soften the frit, while at the same time minimizing heating of the substrates and the OLED material.

It should be readily appreciated that depending on the optical properties of the particular frit and substrates, other types of lasers can be used which operate at different powers, different speeds and different wavelengths. However, the laser wavelength should be within the band of high absorption for the particular frit. One of skill in the art could readily select an appropriate laser for a particular frit.

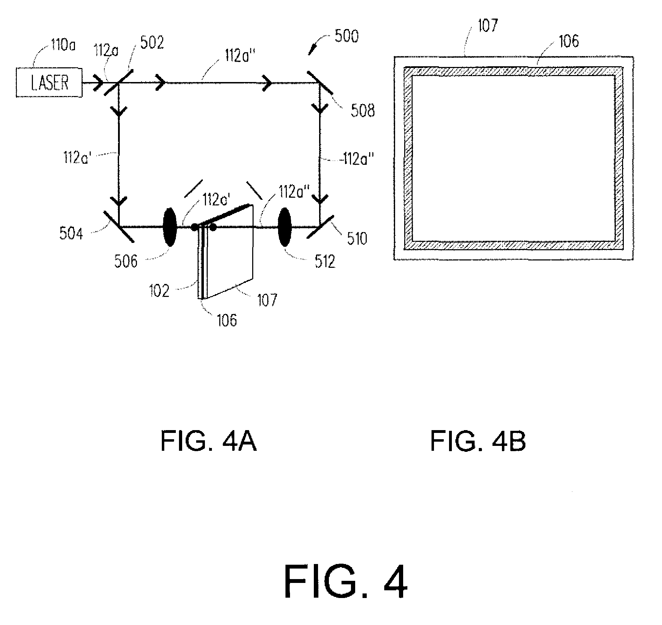

In one aspect, the radiation source can emit a laser beam through a split-beam optics arrangement **500**, as depicted in FIG. 4A, which split the laser beam **112a** into two laser beams **112a'** and **112a"** which are then directed towards the first and second substrates. As illustrated in FIG. 4A, the laser **110a** emits laser beam **112a** towards the split-beam optics arrangement **500** which includes a 50/50 beam splitter **502** that splits the laser beam **112a** into two laser beams **112a'** and **112a"**. The first laser beam **112a'** can be reflected off a mirror **504** so that it is directed through a lens **506** onto the first substrate **102**. The second laser beam **112a"** can be reflected off a series of mirrors **508** and 510 so that it is directed through a lens **512** onto the second substrate **107**. The use of the split-beam optics arrangement **500** to deliver heat to a localized area on the substrates can enable softening and bonding of an exemplary frit in a manner where the temperature distribution and residual stresses are manageable to achieve a reliable sealed assembly. It should be noted that there are many different types of arrangements which could be used in the present invention to split a laser beam so that it interfaces with both substrates.

The light emitting display and method of the present invention offer several advantages over the current practice in industry where an organic adhesive is used to provide a hermetic seal in a light emitting display. First, the light emitting display of the present invention does not require the presence of a desiccant. Second, the rate of degradation of the traditional UV-cured adhesive seal due to moisture is believed to be faster than that of the frit seal in the light emitting display. Third, the proposed method may substantially reduce the cycle time (processing time) of a given component where UV-cured sealing (organic adhesive) commonly requires a post-treatment in a furnace for an extended time. Fourth, the light emitting display is likely to be longer-lived than the traditional epoxy-sealed light emitting displays which offer poor resistance to moisture penetration. Fifth, the light emitting display sealing method can be easily integrated into a manufacturing line.

Although several aspects of the present invention have been illustrated in the accompanying drawings and described in the detailed description, it should be understood that the invention is not limited to the aspects disclosed, but is capable of numerous rearrangements, modifications and substitutions without departing from the spirit of the invention as set forth and defined by the following claims.

**EXAMPLES**

To further illustrate the principles of the present invention, the following examples are put forth so as to provide those of ordinary skill in the art with a complete disclosure and description of how the glass frit compositions, articles, devices, and methods claimed herein are made and evaluated. They are intended to be purely exemplary of the invention and are not intended to limit the scope of what the inventors regard as their invention. Efforts have been made to ensure accuracy with respect to numbers (e.g., amounts, temperatures, etc.); however, some errors and deviations should be accounted for. Unless indicated otherwise, temperature is °C or is at ambient temperature, and pressure is at or near atmospheric. There are numerous variations and combinations of process conditions that can be used to optimize product quality and performance. Only reasonable and routine experimentation will be required to optimize such process conditions.

**Example 1** - **Inventive Frit Compositions**

In a first example, various frit compositions were prepared comprising combinations of oxides. The specific composition of the glass portion of each inventive sample is set forth in Table 2 below. All of the amounts detailed in Table 2 refer to mole percent.

**Table 2 - Inventive Frit Compositions (Glass Portions)**

| Component | Inventive Sample (mole%) | | | | | | | | |
|---|---|---|---|---|---|---|---|---|---|
| | **A** | **B** | **C** | **D** | **E** | **F** | **G** | **H** | **I** |
| $SiO_2$ | 62 | 65 | 59 | 56 | 68 | 68 | 57.5 | 12.7 | 10 |
| $B_2O_3$ | 22.5 | 22 | 20.5 | 22 | 22 | 22 | 27 | 28.4 | 30 |
| $Al_2O_3$ | 4 | 4 | 4 | 7 | 4 | 2 | 4 | 0 | 0 |
| CuO | 8 | 8 | 8 | 14 | 0 | 0 | 8 | 0 | 11 |
| $Fe_2O_3$ | 1.5 | 1 | 1.5 | 1 | 1.1 | 2 | 1.5 | 3.25 | 2 |
| $TiO_2$ | 0.5 | 0 | 0.5 | 0 | 0 | 0.5 | 0.5 | 0 | 0 |
| $Li_2O$ | 1 | 0 | 1 | 0 | 0.8 | 0.5 | 1 | 0 | 0 |
| $V_2O_5$ | 0.5 | 0 | 0.5 | 0 | 1.1 | 2 | 0.5 | 3.25 | 2 |
| $Na_2O$ | 0 | 0 | 0 | 0 | 3 | 3 | 0 | 0 | 0 |
| ZnO | 0 | 0 | 5 | 0 | 0 | 0 | 0 | 52.4 | 45 |

**Example 2 - Preparation of Inventive Frit Powder**

In a second example, the components of Inventive Sample A, described in Table 2 above, were combined. The resulting mixture was heated to about 1,550 °C for approximately 6 hours to melt the components.
The hot mixture was subsequently fractured by pouring into cold water. The fractured pieces were crushed to 325 mesh and then wet milled to an average particle size of approximately 1.9 micrometers.

**Example 3 - Preparation of Fritted Sheet**

In a third example, a fritted sheet was prepared by forming and applying a frit paste to a substrate. A 2 wt. % paste binder solution was initially prepared by dissolving a T-100 ethylcellulose paste binder, available from Hercules, Inc. (Wilmington, Delaware, USA), in TEXANOL®, an ester alcohol, available from Eastman Chemical Company (Kingsport, Tennessee, USA). The following components were then mixed to form a frit paste: 19.09 grams of the T-100/TEXANOL solution prepared above, 55.33 grams of the powdered frit prepared in Example 2, and 0.61 grams of an OC-60 wetting agent, available from Dexter Chemical, L.L.C. (Bronx, New York, USA).
The resulting frit paste was dispensed onto an Eagle borosilicate glass substrate (Corning Inc., Corning, New York, USA), 50 mm long, 50 mm wide, 0.7 mm thick, in a square pattern, approximately 40 mm by 40 mm, with rounded corners.
The applied frit was sintered to the Eagle substrate at 700 °C for approximately 2 hours in a nitrogen environment. The sintered frit was approximately 0.7 mm wide and 0.033 mm thick.

### Example 4 - Sealing and Performance Testing

In a fourth example, a test device was prepared using the sintered frit prepared in Example 3. A calcium film, approximately 30 mm long, 30 mm wide, and 0.5 micrometers thick was deposited on a separate piece of Eagle glass substrate in an inert atmosphere. The substrate onto which the calcium film was deposited was then mated to the fritted sheet prepared in Example 3, encapsulating the calcium film. The frit was melted, fusing both substrates together, using an 810 nanometer continuous wave (CW) laser, operated at 24 Watts and at a speed of 2 mm/sec.

To test the hermeticity of the seal, the test device was then placed in an 85 °C, 85 % relative humidity chamber to accelerate moisture diffusion through the seal. After approximately 180 hours, no visible degradation of the calcium film occurred, indicating that the seal was hermetic.

### Example 5 - Strain Mismatch of Seal Made from Frit

### Composition G

In a fifth example, a frit composition was prepared by combining the components of Inventive Sample G described in Table 2 above. The resulting frit was sintered at approximately 675 °C in a nitrogen environment.

The resulting frit was then applied to an Eagle $^{2000}$ ™ substrate. The strain mismatch between the glass frit and the substrate was approximately 200 ppm. The sample device comprising a 47 micrometer thick frit layer was sealed using an 810 nanometer CW laser at 7.5 Watts and at a speed of about 5 mm/sec. No cracks were observed in the seal, indicating that the CTE of the frit and the substrate were sufficiently similar to provide a crack-free hermetic seal.

### Example 6 - Hermetic Seal Using Frit Composition A

In a sixth example, a frit composition was prepared by combining the components of Inventive Sample A described in Table 2 above. The resulting frit was milled until an average particle size of approximately 1.9 micrometers was achieved. The frit was formulated into a paste and dispensed with a MicroPen® dispensing device onto an Eagle $^{2000}$ ™ borosilicate glass substrate. The deposited frit was fired at about 750 °C for approximately 2 hours in a nitrogen environment. The frit was then sealed to the substrate using an 810 nanometer laser at 10 Watts and at a speed of 9 mm/sec.

The frit sealed substrate was subsequently placed in an 85 °C, 85 % relative humidity chamber for approximately 70 hours to monitor the durability of the frit seal. No cracks were observed due to exposure to the 85/85 environment, indicating that the seal remained hermetic, and thus, likely to be long-lasting.

Throughout this application, various publications are referenced. The disclosures of these publications in their entireties are hereby incorporated by reference into this application in order to more fully describe the compositions, articles, device, and methods described herein.

Various modifications and variations can be made to the compositions, articles, devices, and methods described herein. Other aspects of the compositions, articles, devices, and methods described herein will be apparent from consideration of the specification and practice of the compositions, articles, devices, and methods disclosed herein. It is intended that the specification and examples be considered as exemplary.

**Claims**

1. A frit composition comprising a glass portion comprising:

    a base component comprising:

    from about 5 to about 75 mole % $SiO_2$;
    from about 10 to about 40 mole % $B_2O_3$;
    from 0 to about 20 mole % $Al_2O_3$; and

    at least one absorbing component comprising:

    (a) from greater than 0 to about 25 mole % CuO; or
    (b) from greater than 0 to about 7 mole % $Fe_2O_3$;
    from greater than 0 to about 10 mole % $V_2O_5$; and
    from 0 to about 5 mole % $TiO_2$.

**2.** The frit composition of claim 1, wherein at least absorbing component (a) is present.

**3.** The frit composition of claim 1, wherein at least absorbing component (b) is present.

**4.** The frit composition of claim 1, wherein absorbing components (a) and (b) are both present.

**5.** The frit composition of claim 1, wherein:

$SiO_2$ is from about 50 to about 75 mole %;
$B_2O_3$ is from about 15 to about 30 mole %; and
$Al_2O_3$ is from 0 to about 10 mole %.

**6.** The frit composition of claim 5, wherein the at least one absorbing component comprises:

a) from about 4 to about 18 mole % CuO; or
b) from about 0.1 to about 3 mole % $Fe_2O_3$;
from about 0.1 to about 5 mole % $V_2O_5$; and
from 0 to about 2 mole % $TiO_2$.

**7.** The frit composition of claim 6, wherein $TiO_2$ is from about 0.1 to about 2 mole %.

**8.** The frit composition of claim 6 wherein at least absorbing component (a) is present.

**9.** The frit composition of claim 6, wherein at least absorbing component (b) is present.

**10.** The frit composition of claim 6, wherein absorbing components (a) and (b) are both present.

**11.** The frit composition of claim 5, wherein the at least one absorbing component comprises:

a) from about 8 to about 14 mole % CuO; or
b) from about 1 to about 2 mole % $Fe_2O_3$;
from about 0.5 to about 2 mole % $V_2O_5$; and
from 0 to about 1 mole % $TiO_2$.

**12.** The frit composition of claim 11, wherein $TiO_2$ is from about 0.1 to about 1 mole %.

**13.** The frit composition of claim 1, wherein:

$SiO_2$ is from about 54 to about 70 mole %;
$B_2O_3$ is from about 19 to about 24 mole %; and
$Al_2O_3$ is from 0 to about 10 mole %.

**14.** The frit composition of claim 13, wherein the at least one absorbing component comprises:

a) from about 4 to about 18 mole % CuO; or
b) from about 0.1 to about 3 mole % $Fe_2O_3$;
from about 0.1 to about 5 mole % $V_2O_5$; and
from 0 to about 2 mole % $TiO_2$.

**15.** The frit composition of claim 13, wherein the at least one absorbing component comprises:

a) from about 8 to about 14 mole % CuO; or
b) from about 1 to about 2 mole % $Fe_2O_3$;
from about 0.5 to about 2 mole % $V_2O_5$; and
from 0 to about 1 mole % $TiO_2$

**16.** The frit composition of claim 1, wherein:

$SiO_2$ is from about 5 to about 30 mole %;
$B_2O_3$ is from about 10 to about 40 mole %;
$Al_2O_3$ is from 0 to about 10 mole %; and

further comprising from about 30 to about 60 mole % ZnO.

17. The frit composition of claim 1, wherein:

$SiO_2$ is from about 8 to about 15 mole %;
$B_2O_3$ is from about 25 to about 35 mole %;
$Al_2O_3$ is from 0 to about 10 mole %; and

further comprising from about 40 to about 55 mole % ZnO.

18. The frit composition of claim 1, wherein the glass portion further comprises at least one of:

lithium oxide, sodium monoxide, zinc oxide, potassium oxide, bismuth oxide, nickel oxide, manganese oxide, or a mixture thereof.

19. The frit composition of claim 1, wherein the absorption coefficient of radiation is at least about 2/mm.

20. The frit composition of claim 1, wherein the coefficient of thermal expansion of the frit composition is from about 25 x $10^{-7}$/°C to about 80 x $10^{-7}$/°C.

21. The frit composition of claim 1, further comprising at least one of a binder, filler, solvent, or a mixture thereof.

22. A vanadium based frit composition having a coefficient of thermal expansion substantially similar to that of borosilicate glass, without addition to the frit composition of a coefficient of thermal expansion matching filler.

23. The vanadium based frit composition of claim 22, wherein the frit composition further comprises $Fe_2O_3$.

24. The vanadium based frit composition of claim 22, being free of or substantially free of lead.

25. A copper based frit composition having a coefficient of thermal expansion substantially similar to that of borosilicate glass, without addition to the frit composition of a coefficient of thermal expansion matching filler.

26. The copper based frit composition of claim 25, being free of or substantially free of lead.

27. An article comprising:

a substrate; and
a frit composition comprising a glass portion comprising:

a base component comprising:

from about 5 to about 75 mole % $SiO_2$;
from about 10 to about 40 mole % $B_2O_3$;
from 0 to about 20 mole % $Al_2O_3$; and

at least one absorbing component comprising:

a) from greater than 0 to about 25 mole % CuO; or
b) from greater than 0 to about 7 mole % $Fe_2O_3$;
from greater than 0 to about 10 mole % $V_2O_5$; and
from 0 to about 5 mole % $TiO_2$;

wherein the frit composition is positioned on and affixed to the substrate.

**28.** The article of claim 27, wherein the coefficient of thermal expansion of the glass portion of the frit composition is substantially similar to that of the substrate.

**29.** The article of claim 27, wherein the substrate comprises borosilicate glass, soda-lime glass, or a mixture thereof.

**30.** A glass package comprising:

a first substrate;
a second substrate; and
a frit composition comprising a glass portion comprising:

a base component comprising:

from about 5 to about 75 mole % $SiO_2$;
from about 10 to about 40 mole % $B_2O_3$;
from 0 to about 20 mole % $Al_2O_3$; and

at least one absorbing component comprising:

a) from greater than 0 to about 25 mole % CuO; or
b) from greater than 0 to about 7 mole % $Fe_2O_3$;
from greater than 0 to about 10 mole % $V_2O_5$; and
from 0 to about 5 mole % $TiO_2$;

wherein the frit composition is positioned between the first substrate and the second substrate, and wherein the frit was heated to form a hermetic seal connecting the first substrate to the second substrate.

**31.** The glass package of claim 30, wherein the frit composition absorbs more radiation than either the first substrate or the second substrate.

**32.** The glass package of claim 30, wherein the frit composition has a softening temperature lower than the softening temperature of the first substrate and the second substrate.

**33.** The glass package of claim 30, wherein the glass portion of the frit composition has a coefficient of thermal expansion substantially similar to both the first substrate and the second substrate.

**34.** The glass package of claim 30, further comprising a light emitting layer, wherein the frit composition is positioned between the first and second substrates to form a frame, and the light emitting layer is positioned between the first and second substrates and within the frit frame.

**35.** The glass package of claim 34, wherein the light emitting layer comprises an organic light emitting diode.

**36.** A method for manufacturing a hermetically sealed glass package, comprising the steps of:

providing a first substrate;
providing a second substrate;
providing a frit composition comprising a glass portion comprising:

a base component comprising:

from about 5 to about 75 mole % $SiO_2$;
from about 10 to about 40 mole % $B_2O_3$;
from 0 to about 20 mole % $Al_2O_3$; and

at least one absorbing component comprising:

a) from greater than 0 to about 25 mole % CuO; or
b) from greater than 0 to about 7 mole % $Fe_2O_3$;

from greater than 0 to about 10 mole % $V_2O_5$; and
from 0 to about 5 mole % $TiO_2$;

depositing the frit composition onto either the first or the second substrate; and sealing the first substrate to the second substrate by heating the frit in a manner that would cause the frit composition to soften and form a hermetic seal.

37. The method of claim 36, further comprising the step of heating the frit composition to attach the frit composition to the second substrate before the sealing step.

38. The method of claim 36, wherein the heating step comprises a laser.

FIG. 1A

FIG. 1B

FIG. 1

```
                                              ┌ 200
┌─────────────────────────────────────┐
│       PROVIDE FIRST SUBSTRATE        │────202
└─────────────────────────────────────┘
                    │
                    ▼
┌─────────────────────────────────────┐
│      PROVIDE SECOND SUBSTRATE        │────204
└─────────────────────────────────────┘
                    │
                    ▼
┌─────────────────────────────────────┐
│        DEPOSIT OLEDS ON FIRST        │
│             SUBSTRATE                │──── 206
└─────────────────────────────────────┘
                    │
                    ▼
┌─────────────────────────────────────┐
│      DEPOSIT FRIT ONTO SECOND        │
│             SUBSTRATE                │──── 208
└─────────────────────────────────────┘
                    │
                    ▼
┌─────────────────────────────────────┐
│      ATTACH FRIT TO SECOND           │
│             SUBSTRATE                │──── 210 (OPTIONAL)
└─────────────────────────────────────┘
                    │
                    ▼
┌─────────────────────────────────────┐
│ HEAT FRIT SUCH THAT THE FRIT MELTS   │
│   AND FORMS A HERMETIC SEAL          │
│  THAT CONNECTS FIRST SUBSTRATE       │
│      TO SECOND SUBSTRATE             │────212
└─────────────────────────────────────┘
```

# FIG. 2

FIG. 3

FIG. 4A          FIG. 4B

FIG. 4

European Patent
Office

**EUROPEAN SEARCH REPORT**

Application Number

EP 07 11 4474

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/044383 A (CORNING INC [US]; HAWTOF DANIEL W [US]; REDDY KAMJULA P [US]; STONE II) 27 April 2006 (2006-04-27) * examples 12-20,31 * | 1-38 | INV. C03C3/066 C03C3/091 C03C3/093 C03C8/02 C03C8/04 C03C27/06 B32B17/06 H01L51/52 C03C8/24 C03C27/10 |
| X | US 2004/206953 A1 (MORENA ROBERT [US] ET AL) 21 October 2004 (2004-10-21) * paragraph [0001] * * table 1 * * paragraph [0034] * | 1-38 | |
| X | US 2004/207314 A1 (AITKEN BRUCE G [US] ET AL AITKEN BRUCE G [US] ET AL) 21 October 2004 (2004-10-21) * paragraphs [0001], [0003], [0020] - [0029] * | 1-38 | |
| X,D | & US 2006/009109 A1 (AITKEN BRUCE G [US] ET AL) 12 January 2006 (2006-01-12) | 1-38 | |
| X,D | & US 2005/001545 A1 (AITKEN BRUCE G [US] ET AL) 6 January 2005 (2005-01-06) | 1-38 | |
| X,D | & US 2004/207314 A1 (AITKEN BRUCE G [US] ET AL AITKEN BRUCE G [US] ET AL) 21 October 2004 (2004-10-21) | 1-38 | **TECHNICAL FIELDS SEARCHED (IPC)** C03C B32B |
| X | WO 01/49621 A (CORNING INC [US]; YOUNG DIANNA M [US]) 12 July 2001 (2001-07-12) * examples 3,5 * | 1,2,5,6, 8,13,14, 18-21, 25-38 | H01L |
| X | JP 2004 307329 A (NIPPON ELECTRIC GLASS CO) 4 November 2004 (2004-11-04) * example 3 * | 1,3,16 | |
| X | JP 2004 035297 A (ASAHI GLASS CO LTD) 5 February 2004 (2004-02-05) * example 1 * | 1,2, 16-18, 21,25,26 | |

-/--

The present search report has been drawn up for all claims

| Place of search | Date of completion of the search | Examiner |
|---|---|---|
| Munich | 24 January 2008 | Somann, Karsten |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.................................................................................

& : member of the same patent family, corresponding
document

EPO FORM 1503 03.82 (P04C01)

European Patent
Office

**EUROPEAN SEARCH REPORT**

Application Number

EP 07 11 4474

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 612 193 A (SAMSUNG SDI CO LTD [KR]) 4 January 2006 (2006-01-04) <br><br> * examples 5,7 * <br> ----- | 1,3,16, 18,21, 22,25,26 | |
| X | WO 97/30947 A (CORNING INC [US]; ARAUJO ROGER J [US]) 28 August 1997 (1997-08-28) * the whole document * <br> ----- | 1-38 | |
| E | EP 1 870 383 A (SCHOTT AG [DE]) 26 December 2007 (2007-12-26) * the whole document * <br> ----- | 1-38 | |
| | | | TECHNICAL FIELDS SEARCHED (IPC) |

The present search report has been drawn up for all claims

| Place of search | Date of completion of the search | Examiner |
|---|---|---|
| Munich | 24 January 2008 | Somann, Karsten |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 11 4474

This annex lists the patent family members relating to the patent documents cited in the above-mentioned European search report.
The members are as contained in the European Patent Office EDP file on
The European Patent Office is in no way liable for these particulars which are merely given for the purpose of information.

24-01-2008

| Patent document cited in search report | Publication date | Patent family member(s) | | Publication date |
|---|---|---|---|---|
| WO 2006044383 A | 27-04-2006 | NONE | | |
| US 2004206953 A1 | 21-10-2004 | CA | 2522566 A1 | 04-11-2004 |
| | | CN | 1798708 A | 05-07-2006 |
| | | EP | 1615858 A2 | 18-01-2006 |
| | | JP | 2006524417 T | 26-10-2006 |
| | | KR | 20060011831 A | 03-02-2006 |
| | | US | 2005151151 A1 | 14-07-2005 |
| | | US | 2005116245 A1 | 02-06-2005 |
| | | WO | 2004094331 A2 | 04-11-2004 |
| US 2004207314 A1 | 21-10-2004 | CA | 2522425 A1 | 04-11-2004 |
| | | CN | 1798710 A | 05-07-2006 |
| | | EP | 1620369 A2 | 01-02-2006 |
| | | JP | 2006524419 T | 26-10-2006 |
| | | KR | 20060005369 A | 17-01-2006 |
| | | US | 2006009109 A1 | 12-01-2006 |
| | | US | 2005001545 A1 | 06-01-2005 |
| | | WO | 2004095597 A2 | 04-11-2004 |
| US 2006009109 A1 | 12-01-2006 | CA | 2522425 A1 | 04-11-2004 |
| | | CN | 1798710 A | 05-07-2006 |
| | | EP | 1620369 A2 | 01-02-2006 |
| | | JP | 2006524419 T | 26-10-2006 |
| | | KR | 20060005369 A | 17-01-2006 |
| | | US | 2004207314 A1 | 21-10-2004 |
| | | US | 2005001545 A1 | 06-01-2005 |
| | | WO | 2004095597 A2 | 04-11-2004 |
| US 2005001545 A1 | 06-01-2005 | CA | 2522425 A1 | 04-11-2004 |
| | | CN | 1798710 A | 05-07-2006 |
| | | EP | 1620369 A2 | 01-02-2006 |
| | | JP | 2006524419 T | 26-10-2006 |
| | | KR | 20060005369 A | 17-01-2006 |
| | | US | 2006009109 A1 | 12-01-2006 |
| | | US | 2004207314 A1 | 21-10-2004 |
| | | WO | 2004095597 A2 | 04-11-2004 |
| US 2004207314 A1 | 21-10-2004 | CA | 2522425 A1 | 04-11-2004 |
| | | CN | 1798710 A | 05-07-2006 |
| | | EP | 1620369 A2 | 01-02-2006 |
| | | JP | 2006524419 T | 26-10-2006 |
| | | KR | 20060005369 A | 17-01-2006 |
| | | US | 2006009109 A1 | 12-01-2006 |
| | | US | 2005001545 A1 | 06-01-2005 |
| | | WO | 2004095597 A2 | 04-11-2004 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 07 11 4474

This annex lists the patent family members relating to the patent documents cited in the above-mentioned European search report.
The members are as contained in the European Patent Office EDP file on
The European Patent Office is in no way liable for these particulars which are merely given for the purpose of information.

24-01-2008

| Patent document cited in search report | | Publication date | Patent family member(s) | | Publication date |
|---|---|---|---|---|---|
| WO 0149621 | A | 12-07-2001 | US<br>US | 2002103069 A1<br>6391809 B1 | 01-08-2002<br>21-05-2002 |
| JP 2004307329 | A | 04-11-2004 | NONE | | |
| JP 2004035297 | A | 05-02-2004 | NONE | | |
| EP 1612193 | A | 04-01-2006 | AT<br>CN<br>JP<br>KR<br>US | 376535 T<br>1736916 A<br>2006008496 A<br>20060000515 A<br>2006019814 A1 | 15-11-2007<br>22-02-2006<br>12-01-2006<br>06-01-2006<br>26-01-2006 |
| WO 9730947 | A | 28-08-1997 | DE<br>DE<br>EP<br>JP | 69708058 D1<br>69708058 T2<br>0881995 A1<br>2000505412 T | 13-12-2001<br>16-05-2002<br>09-12-1998<br>09-05-2000 |
| EP 1870383 | A | 26-12-2007 | DE | 102006028763 A1 | 27-12-2007 |

EPO FORM P0459

For more details about this annex : see Official Journal of the European Patent Office, No. 12/82

**EP 1 897 861 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6998776 B
- US 20050001545 A
- US 20060009109 A